# DEMANDE DE BREVET EUROPEEN

(11) **EP 1 075 076 A1**
(43) Date de publication de la demande: **07.02.2001**
(21) Numéro de dépôt: 00402187.9
(22) Date de dépôt: 28.07.2000
(51) Int. Cl.: H02K 11/02, H02K 5/14

(54) **Plaque porte-balais pour moteur électrique, procédé de fabrication de cette plaque et module pour groupe moto-ventilateur comportant cette plaque**

(30) Priorité: 30.07.1999 FR 9909959
(71) Demandeur: ECIA INDUSTRIE, 92100 Boulogne (FR)
(72) Inventeur: Billotte, Christophe, 90100 Delle (FR); Vadrot, Alain, 25350 Mandeure (FR)
(74) Mandataire: Obolensky, Michel

(57) **Abrégé**

La plaque porte-balais comprend un circuit imprimé (CI) comportant un substrat isolant (38) muni d'une face partiellement recouverte de zones (Z) ou pistes (P1, P2) métalliques, dite face conductrice (38C), et au moins un support (40) pour balai alimenté électriquement. Ce support (40) est fixé sur le circuit imprimé de manière à s'étendre du côté de la face conductrice (38C). La fixation du support (40) est réalisée par soudage comme un composant pour montage en surface (CMS).

## Description

La présente invention concerne une plaque porte-balais pour moteur électrique, un procédé de fabrication de cette plaque et un module pour groupe moto-ventilateur comportant cette plaque.

La présente invention s'applique en particulier à un moteur électrique destiné à équiper un groupe moto-ventilateur de véhicule automobile.

On connaît déjà dans l'état de la technique, notamment d'après FR-A-2 582 872 (FR-85 08 159), un plaque porte-balais pour moteur électrique du type à collecteurs et balais, la plaque comprenant :
- un circuit imprimé comportant un substrat isolant muni d'une face partiellement recouverte de zones ou pistes métalliques, dite face conductrice, et
- au moins un support pour balai alimenté électriquement.

La plaque porte-balais décrite dans FR-A-2 582 872 est munie de quatre supports métalliques pour balais comprenant chacun des languettes de fixation sur le circuit imprimé. Chaque support alimente électriquement un balai correspondant et est fixé sur le circuit imprimé de manière à s'étendre du côté de la face isolante de ce circuit imprimé, c'est-à-dire du côté opposé à la face conductrice de ce circuit imprimé. On évite ainsi des contacts indésirables des supports métalliques avec des zones ou pistes métalliques de la face conductrice du circuit imprimé. Les languettes de fixation traversent le substrat du circuit imprimé et sont rabattues contre des pistes métalliques correspondantes alimentées électriquement.

On souhaite de plus en plus fréquemment équiper la plaque porte-balais avec d'autres composants que les supports de balais, en particulier avec des composants électroniques destinés notamment à la régulation de la vitesse du moteur électrique et à l'anti-parasitage. Ces composants électroniques sont en général fixés sur le circuit imprimé de manière à s'étendre du côté de la face conductrice de ce circuit imprimé.

Or, le fait d'agencer les supports de balais du côté de la face isolante du circuit imprimé alors que les autres composants, destinés notamment à la régulation du moteur et à l'anti-parasitage, sont disposés du côté de la face conductrice de ce circuit imprimé, limite les cadences de fabrication des plaques porte-balais et les possibilités de réduction des coûts de production de ces plaques.

L'invention a notamment pour but de proposer une plaque porte-balais du type précité, simple à fabriquer et fiable.

A cet effet, l'invention a pour objet une plaque porte-balais du type décrit dans FR-A-2 582 872, caractérisé en ce que le support pour balai est fixé sur le circuit imprimé de manière à s'étendre du côté de la face conductrice.

Suivant d'autres caractéristiques de cette plaque porte-balais :
- le support comprend au moins deux pattes métalliques de fixation sur la face conductrice, une première patte de fixation étant reliée électriquement à une piste métallique conductrice alimentée électriquement et la seconde patte de fixation étant reliée à une zone métallique séparée ou non de cette piste métallique conductrice ;
- les pattes de fixation sont soudées sur les pistes ou zones métalliques ;
- le support est métallique et enjambe une piste ou zone métallique portée à un potentiel différent de celui de ce support, les pattes de fixation formant des entretoises espaçant le support de la piste ou zone métallique enjambée ;
- les pattes de fixation sont venues de matière avec le support métallique ;
- le circuit imprimé comporte au moins un composant, différent d'un support pour balai, par exemple du type composant pour montage en surface, fixé sur le circuit imprimé de manière à s'étendre du côté de la face conductrice ;
- le circuit imprimé comporte au moins un composant différent d'un support pour balais fixé sur le circuit imprimé de manière à s'étendre du côté opposé à la face conductrice.

L'invention a également pour objet un procédé de fabrication d'une plaque porte-balais pour moteur électrique du type à collecteurs et balais, la plaque comprenant :
- un circuit imprimé comportant un substrat isolant muni d'une face partiellement recouverte de zones ou pistes métalliques, dite face conductrice, et
- au moins un support pour balai alimenté électriquement,
   caractérisé en ce que le support pour balais est fixé sur le circuit imprimé, de manière à s'étendre du côté de la face conductrice, par soudage comme un composant pour montage en surface.

Suivant d'autres caractéristiques de ce procédé :
- le support est soudé sur les zones et/ou pistes métalliques du circuit imprimé par refusion ;
- le support est soudé sur les zones et/ou pistes du circuit imprimé à l'aide de moyens robotisés.

L'invention a encore pour objet un module de moteur électrique destiné à équiper un groupe moto-ventilateur de véhicule automobile, caractérisé en ce qu'il comprend un moteur électrique du type à collecteurs et balais et une plaque porte-balais telle que définie plus haut.

L'invention sera mieux comprise à la lecture de la description qui va suivre, donnée uniquement à titre d'exemple et faite en se référant aux dessins dans lesquels :
- la figure 1 est une vue en coupe axiale d'un module de moteur électrique comprenant une plaque porte-balais selon l'invention ;
- la figure 2 est une vue en perspective de la plaque porte-balais du module illustré sur la figure 1 ;
- la figure 3 est une vue de détail, suivant la flèche 3 de la figure 2, d'un support de balais de la plaque illustrée sur la figure 2.

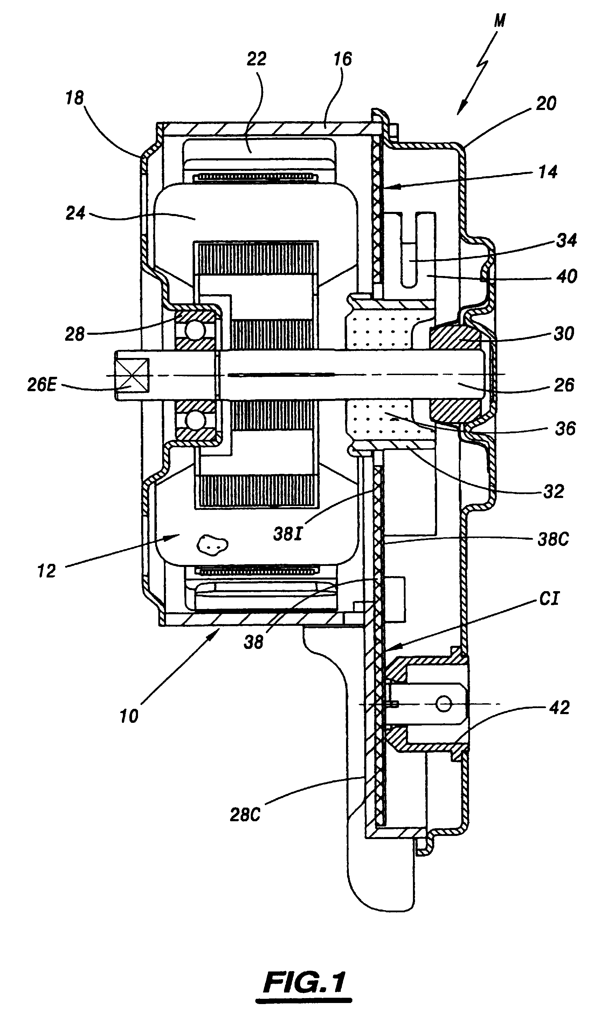

On a représenté sur la figure 1 un module M de moteur électrique destiné à équiper un groupe moto-ventilateur pour véhicule automobile.

Le module M comprend un boîtier 10 dans lequel est logé un moteur électrique classique 12 du type à collecteurs et balais et une plaque porte-balais 14.

Le boîtier 10 comporte un corps 16, de forme générale cylindrique circulaire, obturé par deux couvercles d'extrémité 18, 20.

Le moteur 12 comporte un inducteur 22 à aimants permanents et un induit 24 à enroulements solidaire en rotation d'un arbre 26 porté par deux paliers classiques 28, 30. Ces paliers 28, 30 sont portés par les couvercles 18, 20.

L'arbre 26 comprend une extrémité d'entraînement 26E, destinée à être couplée à un organe classique entraîné, faisant saillie à travers un des couvercles 18, appelé couvercle passant. L'autre couvercle 20 est appelé couvercle masquant.

L'induit 24 est alimenté électriquement par des collecteurs 32 en contact frottant avec des balais 34. Les collecteurs 32 sont portés par une bague isolante 36 solidaire de l'arbre 26. Les balais 34 sont portés par la plaque porte-balais 14, cette dernière étant fixée dans le boîtier 10 de façon connue en soi, par exemple par pincement entre le corps 16 et le couvercle masquant 20.

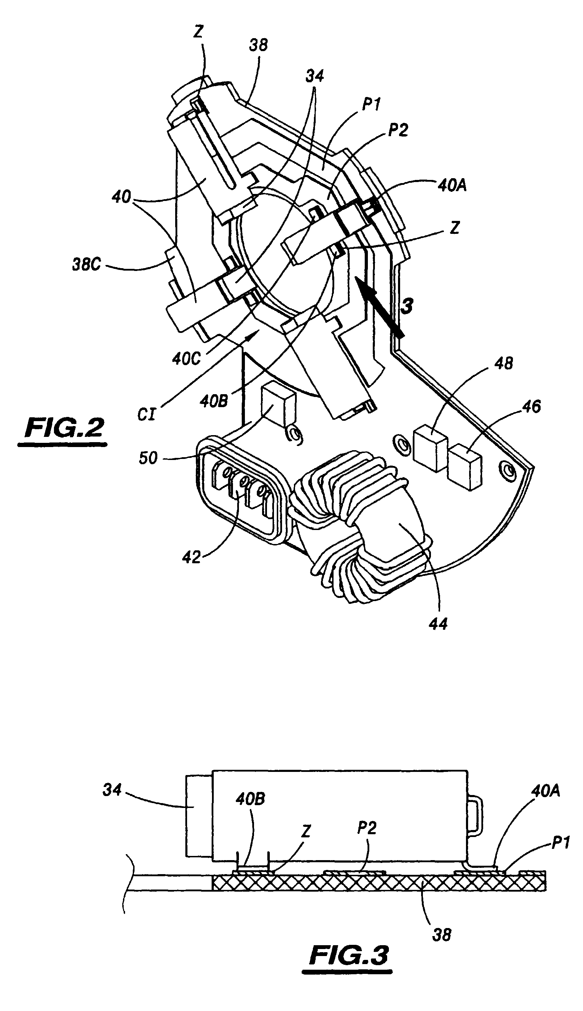

La plaque porte-balais 14 est représentée plus en détail sur la figure 2. Cette plaque 14 comprend un circuit imprimé CI comportant un substrat isolant 38, fabriqué dans un matériau classique, muni d'une face partiellement recouverte de zones Z et de pistes P1, P2 métalliques, notamment en cuivre, dite face conductrice 38C. La face de la plaque 14 opposée à la face conductrice 38C est une face isolante 38I. Les pistes conductrices P1, P2 sont au nombre de deux et sont raccordées de façon connue en soi à des moyens classiques d'alimentation électrique de manière à porter ces deux pistes à des potentiels opposés respectivement.

Dans l'exemple illustré, la plaque 14 porte quatre balais 34 agencés chacun dans un support 40 de balai de forme générale tubulaire, à section sensiblement rectangulaire (voir figures 2 et 3).

Les balais 34 et leur support 40 sont répartis autour d'un cercle centré sur l'axe de l'arbre 26, en deux paires, chaque paire comportant deux balais 34 sensiblement diamétralement opposés.

Les balais 34 d'une même paire sont raccordés électriquement à une piste conductrice commune P1, P2 alimentée électriquement. Les balais 34 d'une même paire sont donc au même potentiel.

De façon classique, chaque balais 34 est monté coulissant dans son support 40 de façon à être rappelé élastiquement au contact des collecteurs 32.

Chaque support 40 est de préférence métallique et comporte des pattes 40A à 40C de fixation sur la face conductrice 38C du circuit imprimé. Ces pattes de fixation métalliques 40A à 40C, par exemple au nombre de trois, sont partiellement découpées dans le support 40 de façon à être venues de matière avec ce support 40.

Les quatre supports 40 sont fixés sur le circuit imprimé de manière à s'étendre chacun du côté de la face conductrice 38C. Les pattes de fixation 40A à 40C des supports sont fixées sur les zones Z et les pistes P1, P2 correspondantes par un procédé de soudage du type utilisé pour un composant classique pour montage en surface (technologie CMS). Le soudage des pattes 40A à 40C est réalisé de préférence par refusion, par exemple à l'aide de moyens robotisés.

Au moins une patte 40A à 40C de chaque support 40 est reliée électriquement par soudage à une piste conductrice correspondante P1, P2 alimentée électriquement (voir figures 2 et 3). Les balais 34, en contact électrique avec leur support 40, sont donc alimentés électriquement par l'intermédiaire de leur support.

Toute patte 40A à 40C d'un support qui n'est pas reliée à une piste conductrice P1, P2 est reliée par soudage à une zone métallique Z séparée ou non de ces deux pistes P1, P2.

Le cas échéant, au moins un des supports 40, tel que celui représenté sur la figure 3, enjambe une piste ou une zone métallique portée à un potentiel différent de celui du support 40.

Ainsi, sur la figure 3, le potentiel du support 40 illustré sur cette figure est celui de la piste P1. La piste enjambée par le support 40 est la piste P2. On notera que les pattes de fixation 40A à 40C forment des entretoises espaçant le support 40 de la piste ou zone métallique enjambée.

Le circuit imprimé CI comporte également des composants supplémentaires, différents des supports 40 pour balais, agencés sur une partie de ce circuit imprimé prolongeant celle portant les supports 40. Ces composants supplémentaires sont de préférence fixés par soudage sur le circuit imprimé de manière à s'étendre du côté de la face conductrice 38C comme les supports 40 pour balais. Ces composants supplémentaires comprennent, par exemple, un connecteur 42 de raccordement électrique du circuit imprimé et du moteur 12 à des moyens classiques d'alimentation électrique, un transformateur électrique 44 et des composants de type CMS 46 à 50 destinés notamment à la régulation de la vitesse du moteur et/ou à l'anti-parasitage.

L'agencement de tous les composants (supports 40 de balais et composants supplémentaires) du côté de la face conductrice 38C simplifie la fabrication de la plaque porte-balais 14 ce qui permet de réduire les coûts de production de cette plaque 14.

Toutefois, si nécessaire, la plaque porte-balais 14 peut comporter au moins un composant fixé sur le circuit imprimé de manière à s'étendre du côté de la face isolante 38I.

On notera sur la figure 1 que le module M comporte également un radiateur 52 de refroidissement de certains composants exothermiques du circuit imprimé. Ce radiateur 52 est agencé du côté de la face isolante 38I du circuit imprimé.

## Revendications

1. Plaque porte-balais pour moteur électrique (12) du type à collecteurs (32) et balais (34), la plaque (14) comprenant :
- un circuit imprimé comportant un substrat isolant (38) muni d'une face (38C) partiellement recouverte de zones (Z) ou pistes (P1, P2) métalliques, dite face conductrice, et
- au moins un support (40) pour balai alimenté électriquement,
**caractérisé en ce que** le support (40) pour balai est fixé sur le circuit imprimé de manière à s'étendre du côté de la face conductrice (38C), et en ce que le support (40) comprend au moins deux pattes métalliques (40A à 40C) de fixation sur la face conductrice (38C), une première patte de fixation étant reliée électriquement à une piste métallique conductrice (P1, P2) alimentée électriquement et la seconde patte de fixation étant reliée à une zone métallique (Z) séparée ou non de cette piste métallique conductrice (P1, P2).

2. Plaque porte-balais selon la revendication 1, caractérisé en ce que les pattes de fixation (40A à 40C) sont soudées sur les pistes ou zones métalliques.

3. Plaque porte-balais selon la revendication 1 ou 2, caractérisée en ce que le support (40) est métallique et enjambe une piste (P1, P2) ou zone (Z) métallique portée à un potentiel différent de celui de ce support (40), les pattes de fixation (40A à 40C) formant des entretoises espaçant le support (40) de la piste (P1, P2) ou zone (Z) métallique enjambée.

4. Plaque porte-balais selon la revendication 3, caractérisé en ce que les pattes de fixation (40A à 40C) sont venues de matière avec le support métallique (40).

5. Plaque porte-balais selon l'une quelconque des revendications précédentes, caractérisé en ce que le circuit imprimé comporte au moins un composant (48 à 50), différent d'un support (40) pour balai, par exemple du type composant pour montage en surface (CMS), fixé sur le circuit imprimé de manière à s'étendre du côté de la face conductrice (38C).

6. Plaque porte-balais selon l'une quelconque des revendications précédentes, caractérisé en ce que le circuit imprimé comporte au moins un composant différent d'un support (40) pour balais fixé sur le circuit imprimé de manière à s'étendre du côté opposé à la face conductrice (38C).

7. Procédé de fabrication d'une plaque porte-balais pour moteur électrique (12) du type à collecteurs (32) et balais (34), la plaque (14) comprenant :
- un circuit imprimé comportant un substrat isolant (38) muni d'une face (38C) partiellement recouverte de zones (Z) ou pistes (P1, P2) métalliques, dite face conductrice, et
- au moins un support (40) pour balai alimenté électriquement,
caractérisé en ce que le support (40) pour balais est fixé sur le circuit imprimé, de manière à s'étendre du côté de la face conductrice (38C), par soudage comme un composant pour montage en surface (CMS).

8. Procédé selon la revendication 7, caractérisé en ce que le support (40) est soudé sur les zones et/ou pistes métalliques du circuit imprimé par refusion.

9. Procédé selon la revendication 7 ou 8, caractérisé en ce que le support (40) est soudé sur les zones et/ou pistes du circuit imprimé à l'aide de moyens robotisés.

10. Module de moteur électrique destiné à équiper un groupe moto-ventilateur de véhicule automobile, caractérisé en ce qu'il comprend un moteur électrique (12) du type à collecteurs (32) et balais (34) et une plaque porte-balais selon l'une quelconque des revendications 1 à 6.
